# FASCICULE DE BREVET EUROPEEN

(11) **EP 4 541 548 B1**
(45) Date de publication et mention de la délivrance du brevet: **11.02.2026**
(21) Numéro de dépôt: 24206658.7
(22) Date de dépôt: 15.10.2024
(51) Int. Cl.: B29C 35/02, B29C 35/08, B29C 64/124, B29C 64/282, B29C 64/386, B29C 64/393, B33Y 10/00, B33Y 50/00, B33Y 50/02, H01L 21/66, B05D 3/06

(54) **PROCÉDÉ D'IRRADIATION SÉLECTIVE CONTRÔLÉE EN TEMPS RÉEL D'UNE DOSE PRÉDÉTERMINÉE SUR UNE ZONE CIBLE D'UNE SURFACE, ET SYSTÈME CORRESPONDANT**
VERFAHREN ZUR SELEKTIVEN ECHTZEITGESTEUERTEN BESTRAHLUNG EINER VORBESTIMMTEN DOSIS AUF EINEM ZIELBEREICH EINER OBERFLÄCHE UND SYSTEM DAFÜR
METHOD FOR THE REAL-TIME CONTROLLED SELECTIVE IRRADIATION OF A PREDETERMINED DOSE ON A TARGET AREA OF A SURFACE, AND CORRESPONDING SYSTEM

(30) Priorité: 20.10.2023 FR 2311413
(43) Date de publication de la demande: 23.04.2025
(73) Titulaire: Ebica, 44830 Bouaye (FR)
(72) Inventeur: ETIENNE, Stéphane, 44830 BOUAYE (FR)
(74) Mandataire: RVDB Nantes

(56) Documents cités:
- US-A1- 2015 298 166
- US-A1- 2019 308 372

## Description

### Domaine technique de l'invention

La présente invention concerne le domaine général de l'irradiation de surfaces par rayonnements énergétiques.

L'invention concerne plus particulièrement un procédé d'irradiation sélective contrôlée d'une zone cible d'une surface mettant en œuvre un système comprenant un dispositif programmable émetteur, au moins un dispositif de mesure et d'analyse et un dispositif contrôleur, ces dispositifs étant reliés les uns aux autres en une boucle fermée. Dans ce procédé, le dispositif contrôleur contrôle en temps réel le dispositif émetteur pendant le processus d'irradiation, en fonction des données relatives à l'énergie réelle mesurée au niveau de la zone cible irradiée et de l'effet réel obtenu au niveau de cette zone cible. Ce procédé selon l'invention est également apte à prendre en compte les énergies collatérales mesurées autour de la zone cible irradiée.

### Arrière-plan technique

Il est connu de l'Homme de l'art des procédés d'irradiation, notamment adaptés au domaine de la fabrication additive. Ainsi on peut citer le procédé décrit dans la demande de brevet DE102015216583 A1, qui est mis en œuvre par un système d'irradiation comprenant d'une part une source émettrice de rayonnements énergétiques tels que des rayons laser, et d'autre part un dispositif de contrôle configuré pour régler la source émettrice de rayonnement en fonction de l'objet à fabriquer. Ce réglage de la source émettrice par le dispositif de contrôle est fonction de paramètres préalablement entrés dans le dispositif de contrôle : celui-ci peut alors contrôler la source émettrice pour qu'elle atteigne les paramètres énergétiques prédéterminés qui lui sont associés.

Cependant, un tel procédé présente l'inconvénient de ne pas pouvoir prendre en compte l'avancée réelle de la fabrication de l'objet, et ainsi contrôler la source émettrice en fonction de données prédéterminées et tout à la fois de données mesurées en temps réel. Pour pallier cet inconvénient, de nouveaux procédés de fabrication additive par irradiation ont été développés : on peut notamment citer le procédé divulgué dans le brevet EP3311983 B1, qui est capable de contrôler en temps réel la source émettrice pendant l'irradiation, pour s'adapter à l'objet réel en fabrication. Pour cela, le procédé d'irradiation de EP3311983 B1 est mis en œuvre par un système d'irradiation qui comprend en outre un dispositif capable de mesurer l'énergie émise par le rayonnement de la source émettrice au niveau de la zone irradiée, et de transmettre ces données mesurées au dispositif de contrôle. Ce dispositif de contrôle est alors en mesure d'adapter la puissance et/ou l'intensité du rayonnement énergétique émis par la source émettrice pendant le processus d'irradiation pour que l'énergie effectivement émise ne dévie pas des paramètres énergétiques de base.

Cependant, bien que ce procédé permette un contrôle en temps réel de la source émettrice, il ne permet toujours pas de contrôler cette source émettrice pour qu'elle soit capable de prendre en compte le résultat effectivement attendu, en dehors des paramètres énergétiques de base : le dispositif de contrôle n'est ainsi pas en mesure de contrôler la source émettrice pour :
- qu'elle s'arrête lorsque la fabrication du produit attendu est terminée, et ce même si les paramètres de base ne sont pas atteints, ou
- que la source continue d'émettre des rayonnements énergétiques alors que les paramètres de base sont atteints (la fabrication du produit attendu n'étant pas terminée). Dans le procédé de EP3311983 B1, la puissance ou l'intensité énergétique de la source émettrice peuvent être ajustées, et notamment réduites, voire même éteintes, si le dispositif de contrôle détermine que la dose énergétique seuil est atteinte, ou à l'inverse, augmentées pour atteindre ce seuil. Mais le procédé de EP3311983 B1 ne permet pas au dispositif de contrôle de déterminer si les paramètres énergétiques de base permettent effectivement d'atteindre le résultat final attendu. Il en résulte qu'un tel système d'irradiation présente l'inconvénient soit d'engendrer des pertes énergétiques et de temps, si la source émettrice continue d'émettre des rayonnements alors que le résultat final est déjà atteint, soit de ne pas atteindre le résultat voulu, si la source s'arrête car elle a atteint les paramètres énergétiques de base, mais que le résultat final n'est pas atteint.

Il existe donc un besoin pour de nouveaux procédés et systèmes d'irradiation par rayonnements énergétiques qui s'adaptent de façon efficace en temps réel au résultat effectivement obtenu au niveau de la surface irradiée, tout en permettant de réduire les pertes.

La demande de brevet US 2015/298166 A1 décrit un procédé d'irradiation sélective contrôlée d'une zone cible d'une surface d'une couche de matière. Selon son résumé, le document US 2015/298166 A1 concerne un procédé permettant de revêtir un substrat d'un revêtement ou d'une poudre de revêtement. Le substrat est divisé en plusieurs champs cibles, balayés par plusieurs lasers après préchauffage par un laser distinct. Un système d'asservissement en temps réel et en boucle fermée permet de surveiller le processus de revêtement. Grâce à la surveillance du champ cible, lors de l'application du revêtement ou de la poudre, les paramètres des lasers sont modifiés en temps réel pour assurer un revêtement uniforme du substrat.

### Résumé de l'invention

Dans ce but, l'invention propose, selon un premier objet, un procédé d'irradiation sélective contrôlée d'une zone cible d'une surface d'un produit ou d'un être vivant donné, pour permettre la radiation locale de cette zone cible en vue d'obtenir un effet cible, ce procédé étant mis en œuvre par un système comprenant un dispositif émetteur, au moins un dispositif de mesure et d'analyse et un dispositif contrôleur. Ce procédé comprend les étapes suivantes :
A) segmentation de la surface en une pluralité de zones ;
B) entrée dans le dispositif contrôleur de seuils énergétiques principaux prédéterminés respectivement associés à chacune des zones, et entrée de l'effet cible à obtenir ;
C) choix de la zone cible parmi les zones et leurs combinaisons ;
D) irradiation de la zone cible par émission de rayonnements énergétiques par le dispositif émetteur, cette émission étant contrôlée par le dispositif contrôleur dans le but d'atteindre les seuils énergétiques principaux prédéterminés ;
E) mesure et enregistrement en temps réel, par le dispositif de mesure et d'analyse, de l'énergie réelle générée par les rayonnements énergétiques au niveau de la zone cible ;
F) analyse et enregistrement, par le dispositif de mesure et d'analyse, de l'effet réel obtenu au niveau de la zone cible irradiée ;
G) transmission de la mesure de l'énergie réelle et de l'analyse de l'effet réel au dispositif contrôleur ;
H) contrôle en temps réel du dispositif émetteur par le dispositif contrôleur au cours du procédé d'irradiation, en prenant en compte la mesure de l'énergie réelle et l'analyse de l'effet réel reçues,
la mesure d'énergie réelle étant comparée au seuil énergétique principal prédéterminé associé à la zone cible, et l'analyse de l'effet réel étant comparée à l'effet cible, de manière à ce que :
- H1) si le seuil énergétique principal n'est pas atteint et l'effet cible n'est pas obtenu, l'émission de rayonnements énergétiques sur la zone cible continue et la puissance et/ou l'intensité des rayonnements énergétiques sont modulées pour obtenir l'effet cible ;
- H2) si le seuil énergétique principal est atteint mais l'effet cible n'est pas obtenu, l'émission de rayonnements énergétiques sur la zone cible continue et la puissance et/ou l'intensité des rayonnements énergétiques sont modulées pour obtenir l'effet cible ;
- H3) si le seuil énergétique principal est atteint et l'effet cible est obtenu, l'émission de rayonnements énergétiques sur la zone cible est stoppée ;
- H4) si le seuil énergétique principal n'est pas atteint mais l'effet cible est obtenu, l'émission de rayonnements énergétiques sur la zone cible est stoppée.

Un tel procédé selon l'invention permet ainsi de contrôler l'irradiation en temps réel d'une zone cible, en prenant en compte des paramètres de base d'énergie et d'effet cible, mais également en prenant en compte l'énergie réelle ressentie au niveau de la zone cible et l'effet réel obtenu au niveau de cette zone. Ainsi, contrairement aux procédés d'irradiation de l'art antérieur, selon le procédé de l'invention, les paramètres énergétiques prédéterminés, qui servent de guide pour conduire le processus d'irradiation, ne sont pas nécessairement atteints lorsque cela n'est pas utile : en effet, ce procédé selon l'invention est capable de déterminer que l'irradiation peut être stoppée car l'effet cible, qui est analysé en parallèle de la mesure de l'énergie réelle, est déjà obtenu, bien que les paramètres énergétiques réels ne correspondent pas tout à fait aux paramètres énergétiques de base. A l'inverse, selon le procédé de l'invention, et toujours contrairement aux procédés d'irradiation de l'art antérieur, il peut être déterminé que l'irradiation effective de la zone cible doit continuer, bien que les paramètres prédéterminés soient déjà atteints, ce qui permet d'obtenir l'effet attendu de façon certaine. De plus, si une comodalité de tendances des paramètres correctifs est validée, les paramètres initiaux sont auto-corrigés.

Cette modulation des paramètres énergétiques en temps réel, et en particulier l'arrêt de l'émission des rayonnements énergétiques dès qu'il est déterminé que l'effet cible est obtenu, permet avantageusement de réduire les pertes énergétiques et financières habituellement liées aux procédés d'irradiation classiques, puisque l'irradiation continue et inutile de la zone cible pour laquelle l'effet cible est déjà atteint est limitée, voir supprimée. De plus, le fait de pouvoir concentrer l'irradiation sur une zone cible déterminée permet de n'irradier localement que la surface requise, en minimisant, voire en supprimant, l'irradiation périphérique, qui est une des causes majeures des pertes énergétiques et financières dans les procédés d'irradiation connus. Cet avantage s'illustre également très clairement dans le domaine de la santé, par exemple par la minimisation des risques de brûlures au niveau des zones entourant la zone cible irradiée.

Pour améliorer le contrôle de l'irradiation d'une zone cible, il est également possible de saisir des paramètres de durée dans le dispositif contrôleur. Par exemple, les paramètres de durée peuvent être représentatifs d'une durée minimale d'irradiation, afin de s'assurer que la zone cible est au moins irradiée pendant cette durée minimale. Il est à noter que la durée minimale d'irradiation correspond, de préférence, à une durée prédéterminée permettant d'atteindre l'effet cible attendu. Cette durée minimale dépend notamment des conditions d'irradiation, c'est-à-dire de la puissance et/ou de l'intensité du rayonnement émis par le dispositif émetteur pendant l'irradiation de la zone cible. Un tel procédé peut être mis en œuvre dans tous les domaines qui impliquent l'irradiation d'une matière dans un but donnée. Ainsi, par exemple, ce procédé peut être mis en œuvre dans le domaine de la micro-électronique, pour fabriquer des pièces de semi-conducteurs par fabrication additive : l'effet cible correspond dans ce cas à la solidification d'au moins une portion d'une couche de matière selon un procédé de polymérisation par irradiation. Ce procédé peut également être mis en œuvre dans le domaine médical : l'effet correspond dans ce cas à la destruction d'une tumeur par irradiation. Ce procédé peut encore être mis en œuvre dans le domaine de la cosmétique, notamment dans l'onglerie : l'effet cible correspond dans ce cas à la solidification d'une couche de vernis sur un ongle via la polymérisation par irradiation.

Selon un mode de réalisation, le procédé selon l'invention comprend en outre les étapes suivantes :
A') entrée dans le dispositif contrôleur de seuils énergétiques secondaires prédéterminés respectivement associés à chacune desdites zones ;
B') mesure et enregistrement en temps réel, par le dispositif de mesure et d'analyse, de l'énergie réelle collatérale, générée au niveau d'au moins une zone de la pluralité de zones qui est adjacente à la zone cible, cette énergie réelle collatérale étant générée par les rayonnements énergétiques irradiant la zone cible ;
C') transmission de la mesure de l'énergie réelle collatérale au dispositif contrôleur ;
D') contrôle en temps réel du dispositif émetteur par le dispositif contrôleur au cours du procédé d'irradiation, en prenant en compte la mesure de l'énergie réelle collatérale, cette mesure de l'énergie réelle collatérale étant comparée au seuil énergétique secondaire prédéterminé associé à l'au moins une zone de la pluralité de zones qui est adjacente à la zone cible, de manière à ce que :
   si le seuil énergétique secondaire de l'au moins une zone adjacente à la zone cible est atteint, la puissance et/ou l'intensité des rayonnements énergétiques irradiant la zone cible (C) sont modulées pour réduire l'énergie réelle collatérale.

Il est ainsi également possible, selon le procédé de l'invention, de moduler la source émettrice en fonction de paramètres secondaires, et notamment en fonction de l'énergie collatérale ressentie et mesurée au niveau des zones adjacentes à la zone cible irradiée. De la même manière que pour le contrôle de la source émettrice en fonction de l'énergie réelle mesurée au niveau de la zone cible irradiée, le système de l'invention est capable de comparée l'énergie réelle des zones adjacentes à la zone cible à des seuils énergétiques au niveau de ces zones, qui correspondent à des seuils dits secondaires, pris en compte lorsque les zones associées à ces seuils ne sont pas des zones cibles, mais des zones collatérales à la zone cible. Le procédé selon l'invention permet donc avantageusement un contrôle très précis de l'irradiation de la zone cible, en fonction de paramètres de différents niveaux (principaux et secondaires), qui ne sont pas forcément liés à la zone effectivement irradiée.

Selon un mode de réalisation, le procédé selon l'invention comprend en outre les étapes suivantes, lorsque la couche de matière est déposée sur un substrat :
I) entrée dans le dispositif contrôleur d'un seuil énergétique maximal associé au substrat ;
J) mesure et enregistrement en temps réel, par le dispositif de mesure et d'analyse, de l'énergie effective générée au niveau du substrat ;
K) transmission de la mesure de l'énergie effective au dispositif contrôleur ;
L) contrôle en temps réel du dispositif émetteur par le dispositif contrôleur au cours du procédé d'irradiation, en prenant en compte la mesure de l'énergie effective,
la mesure de l'énergie effective étant comparée au seuil énergétique maximal, de manière à ce que, si l'énergie effective est supérieure au seuil énergétique maximal, la puissance et/ou l'intensité des rayonnements énergétiques irradiant la zone cible sont modulées pour réduire l'énergie effective au niveau du substrat.

Ainsi, le procédé selon l'invention est en mesure d'analyser l'état de la zone de la couche de matière qui est irradiée et simultanément d'analyser l'état du substrat sur lequel cette couche de matière est déposée. Ce procédé permet donc avantageusement d'irradier une zone d'une couche d'une première matière en prenant en compte l'état d'une couche d'une deuxième matière présente dans l'environnement de cette première couche, et de moduler cette opération d'irradiation dans le but de préserver cette deuxième couche de matière. Par exemple, dans le cas où la couche de matière irradiée est déposée sur un substrat électronique, pour former un composé électronique, ce procédé d'irradiation prenant en compte le substrat électronique permet de polymériser la couche de matière en surface et de ne pas endommager le composé électronique.

Selon un mode de réalisation, le procédé selon l'invention comprend en outre les étapes suivantes :
l') entrée dans le dispositif contrôleur d'un seuil énergétique intermédiaire associé au substrat, ainsi que d'une durée maximale associée au seuil énergétique intermédiaire ;
M) contrôle en temps réel du dispositif émetteur par le dispositif contrôleur au cours du procédé d'irradiation, en prenant en compte la mesure de l'énergie effective,
la mesure de l'énergie effective étant comparée au seuil énergétique intermédiaire, et lorsque l'énergie effective correspond au seuil énergétique intermédiaire, le dispositif de mesure et d'analyse mesure et enregistre en temps réel une durée effective correspondant à la durée pendant laquelle l'énergie effective correspond au seuil énergétique intermédiaire, et le dispositif contrôleur compare la durée effective à la durée maximale, de manière à ce que, si la durée effective est supérieure à la durée maximale, la puissance et/ou l'intensité des rayonnements énergétiques irradiant la zone cible sont modulées pour réduire l'énergie effective au niveau du substrat.

Ce procédé selon l'invention est donc avantageusement en mesure d'implémenter une analyse fine et précise de l'état du substrat. Cela permet de mettre en œuvre, en temps réel, une irradiation effective de la couche de matière recouvrant ce substrat qui est adaptée à l'environnement dans lequel cette couche de matière est intégrée.

Selon un mode de réalisation particulier, la zone cible correspond à la totalité de la surface. Le procédé selon l'invention, qui permet de contrôler le dispositif émetteur en temps réel, permet d'irradier une partie seulement de la zone cible, ou l'entièreté de celle-ci.

Selon un mode de réalisation particulier, le dispositif émetteur est fixe et choisi parmi une matrice comprenant une pluralité de sources émettrices indépendantes et au moins une source émettrice associée à un galvanomètre optique.

Par matrice, au sens de l'invention, il est entendu un élément support ou un cadre, permettant d'intégrer une pluralité de sources émettrices.

Ainsi, lorsque le dispositif émetteur est une matrice comprenant une pluralité de sources émettrices indépendantes, le contrôle du dispositif émetteur par le dispositif contrôleur peut correspondre à l'activation et/ou la désactivation d'une ou plusieurs des multiples sources émettrices composant le dispositif émetteur, en fonction de l'énergie réelle mesurée et de l'effet réel analysé au niveau de la zone cible. Par exemple, le procédé selon l'invention permet au dispositif contrôleur de réduire la puissance et/ou l'intensité énergétique de certaines sources émettrices du dispositif émetteur, voire d'en désactiver certaines, si le dispositif contrôleur détermine que l'énergie réelle au niveau de certaines portions de la zone cible se rapproche, voire atteint ou dépasse, le seuil énergétique principal prédéterminé, et que l'effet cible est proche d'être obtenu, voire est déjà obtenu. A l'inverse, ce procédé d'irradiation permet également au dispositif contrôleur d'augmenter la puissance et/ou l'intensité énergétique de certaines sources émettrices du dispositif émetteur, voire d'en activer certaines, si le dispositif contrôleur détermine que l'énergie réelle au niveau de certaines portions de la zone cible est inférieure au seuil énergétique principal prédéterminé, et que l'effet cible n'est pas obtenu. Par exemple, la source émettrice qui est associée au galvanomètre optique est une source laser.

Selon un mode de réalisation particulier, lorsque le dispositif émetteur est une matrice comprenant une pluralité de sources émettrices indépendantes, ces sources émettrices indépendantes sont des LED.

Les LED sont des dispositifs faciles à intégrer au système de l'invention, simples à mettre en œuvre et à manipuler, et peu couteux.

Selon un autre mode de réalisation, le dispositif émetteur est constitué d'une pluralité de sources émettrices associées à un galvanomètre optique unique.

Selon un exemple de ce mode de réalisation, un tel dispositif émetteur est constitué de plusieurs sources émettrices qui sont des sources laser, par exemple trois, quatre, cinq ou encore six sources laser, et d'un galvanomètre optique unique. Les sources émettrices sont, de préférence, toutes intégrées dans une même matrice support.

Ces sources laser sont, de préférence, chacune définie par des propriétés différentes, notamment en termes de longueur d'onde du rayonnement émis. Les sources laser sont indépendantes les unes des autres, et sont, par exemple, modulées indépendamment les unes des autres.

Selon un autre exemple de ce mode de réalisation, un tel dispositif émetteur est constitué de cinq sources laser disposées à 72° les unes des autres, selon une forme de cercle, et d'un galvanomètre optique intégré au centre de ce cercle.

Dans le système de l'invention selon ces deux exemples, le galvanomètre optique est, en particulier, configuré pour combiner les rayonnements énergétiques émis par chacune des sources émettrices en un rayonnement énergétique unique. Le galvanomètre est également configuré pour réorienter le rayonnement énergétique unique vers une zone cible de la surface à irradier.

Selon un mode de réalisation, le dispositif émetteur est mobile, tel qu'une source mobile embarquée sur un axe.

Selon un mode de réalisation particulier, le dispositif de mesure et d'analyse est un capteur d'imagerie thermique et/ou radiatif, associé à un module d'analyse d'image.

Ainsi, le dispositif de mesure et d'analyse mis en œuvre dans le procédé d'irradiation selon l'invention est capable tout à la fois de mesurer l'énergie réelle au niveau de la zone cible et l'énergie réelle au niveau des zones adjacentes à la zone cible, et d'analyser l'avancement/l'état de l'effet réel au niveau de la zone cible, tout en évitant d'endommager la cible. Il peut donc transmettre ces deux types de données au dispositif contrôleur, qui est alors apte à déterminer comment contrôler le dispositif émetteur pour atteindre les seuils énergétiques prédéterminés et tout à la fois l'effet cible attendu.

Selon un mode de réalisation particulier, le dispositif contrôleur est une interface Humain-Machine.

Une telle interface est facile à intégrer au système de l'invention, et simple à mettre en œuvre et à manipuler.

Selon un mode de réalisation particulier, les radiations énergétiques sont choisies parmi les radiations de lumière visible, infra-rouges, gamma, ultra-violettes, laser, les micro-ondes, les rayons X, et le déploiement thermique convectif ou conductif.

Le procédé selon l'invention peut ainsi avantageusement s'adapter à tout type d'irradiation, et peut, selon au moins un mode de réalisation, les combiner.

Selon un deuxième objet, l'invention propose un système d'irradiation sélective contrôlée d'une zone cible d'une surface d'un produit ou d'un être vivant donné, segmentée en une pluralité de zones, ce système mettant en œuvre le procédé tel que décrit précédemment, et comprenant :
- un dispositif émetteur, configuré pour irradier la zone cible par des rayonnements énergétiques,
- au moins un dispositif de mesure et d'analyse, configuré pour mesurer l'énergie réelle générée par les rayonnements énergétiques au niveau de la zone cible et l'énergie réelle collatérale générée au niveau d'au moins une zone de la pluralité de zones qui est adjacente à la zone cible, ainsi que pour analyser l'effet réel obtenu au niveau de la zone cible irradiée,
- un dispositif contrôleur, configuré pour recevoir des seuils énergétiques prédéterminés principaux et secondaires, respectivement associés à chacune des zones et un effet cible à obtenir, ainsi que pour recevoir la mesure de l'énergie réelle et l'énergie réelle collatérale générée au niveau d'au moins une zone de la pluralité de zones qui est adjacente à la zone cible, ainsi que l'analyse de l'effet réel,

le dispositif contrôleur comprenant des moyens de comparaison de la mesure d'énergie réelle au seuil énergétique principal prédéterminé associé à la zone cible, de la mesure de l'énergie réelle collatérale au seuil énergétique secondaire prédéterminé de l'au moins une zone adjacente à la zone cible, et de l'analyse de l'effet réel à l'effet cible,
le dispositif contrôleur étant en outre configuré pour contrôler le dispositif émetteur en temps réel au cours du procédé d'irradiation par arrêt de l'émission des rayonnements énergétiques, et/ou par modulation de la puissance et/ou l'intensité des rayonnements énergétiques, et/ou par modulation sélective des zones irradiées.

Ce système présente au moins les mêmes avantages que ceux présentés en relation avec le procédé correspondant. Il correspond à une boucle fermée, qui est avantageusement entièrement traçable.

Selon un mode de réalisation, le dispositif de mesure et d'analyse du système est en outre configuré pour mesurer l'énergie effective au niveau d'un substrat sur lequel la couche de matière a été déposée, et dans lequel le dispositif contrôleur est en outre configuré pour recevoir un seuil énergétique maximal associé au substrat, le dispositif contrôleur comprenant en outre des moyens de comparaison de la mesure d'énergie effective au seuil énergétique maximal.

Selon un mode de réalisation particulier, le dispositif contrôleur du système est en outre configuré pour recevoir un seuil énergétique intermédiaire associé au substrat et une durée maximale associée au seuil énergétique intermédiaire, le dispositif contrôleur comprenant en outre des moyens de comparaison de la mesure d'énergie effective au seuil énergétique intermédiaire, et dans lequel, lorsque l'énergie effective correspond au seuil énergétique intermédiaire, le dispositif de mesure et d'analyse est en outre configuré pour mesurer la durée effective pendant laquelle l'énergie effective correspond au seuil énergétique intermédiaire, et le dispositif contrôleur comprenant en outre des moyens de comparaison de la durée effective à la durée maximale d'irradiation.

Ainsi, le système selon l'invention est en mesure d'analyser la couche de matière irradiée et simultanément d'analyser le substrat sur lequel elle repose, et ce de façon précise, afin de permettre le contrôle en temps réel de l'irradiation par le dispositif émetteur permettant de polymériser la couche de matière en surface sans endommager le substrat, ni même d'ailleurs sans endommager l'élément ou le composé qui comprend cet ensemble couche de matière irradiée/substrat.

Selon un mode de réalisation particulier, le dispositif de mesure et d'analyse comprend :
- au moins un moyen de mesure et d'enregistrement configuré pour mesurer l'énergie réelle générée par les rayonnements énergétiques au niveau de la zone cible, et l'énergie réelle collatérale au niveau d'au moins une zone adjacente à la zone cible, et, lorsque le dispositif de mesure et d'analyse est en outre configuré pour mesurer l'énergie effective au niveau du substrat, le moyen de mesure et d'enregistrement est en outre configuré pour mesurer l'énergie effective et la durée effective au niveau du substrat, et
- au moins un moyen d'analyse et d'enregistrement configuré pour analyser l'effet réel obtenu au niveau de la zone cible irradiée.

Ce dispositif joue donc un rôle important dans le fait de pouvoir prendre en compte l'énergie réelle ressentie au niveau de la zone cible et tout à la fois l'état de l'effet réel au niveau de cette zone. Tout au long du procédé d'irradiation, ces deux types de données sont comparées aux données équivalentes de base, via le dispositif contrôleur, qui est alors en mesure de déterminer si l'effet cible attendu est effectivement obtenu ou non au niveau de la zone cible, et qui peut en conséquence contrôler le dispositif émetteur à la demande dans le but final d'obtenir l'effet cible sur la zone cible. Par ailleurs, les paramètres secondaires, relatifs aux zones adjacentes à la zone cible effectivement irradiée, ainsi que les paramètres relatifs au substrat sur lequel repose la couche de matière irradiée, sont également monitorés, afin d'assurer que les variations de paramètres de la source émettrice n'impactent pas l'intégrité de la cible. Une analyse de tendances des variations de paramètres de la cible (AI) est effectuée par itérations afin d'ajuster les paramètres prédéterminés.

### Brève description des figures

D'autres caractéristiques et avantages de l'invention apparaitront au cours de la lecture de la description détaillée qui va suivre pour la compréhension de laquelle on se reportera au dessin annexé dans lequel :
[Fig.1] - la figure 1 schématise le système d'irradiation sélective contrôlée selon un exemple de réalisation de l'invention ;
[Fig.2] - la figure 2 schématise le système d'irradiation sélective contrôlée selon un autre exemple de réalisation de l'invention ;
[Fig.3] - la figure 3 schématise le système d'irradiation sélective contrôlée selon encore un autre exemple de réalisation de l'invention.

### Description détaillée de l'invention

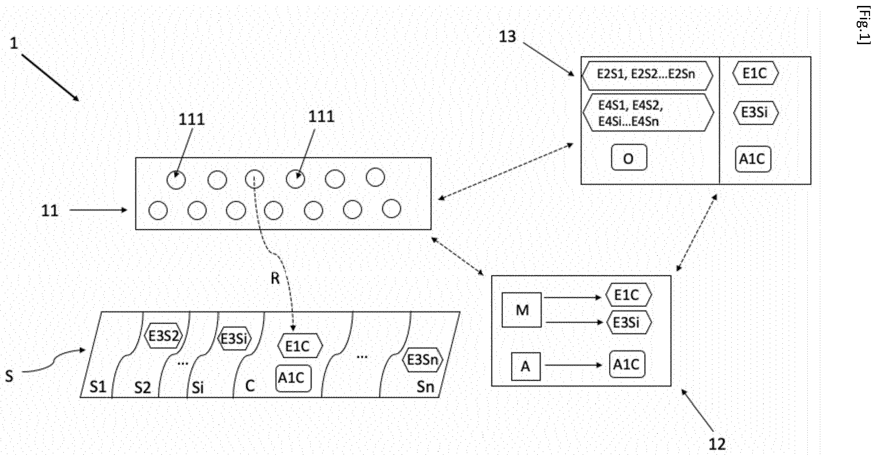

Le procédé d'irradiation sélective contrôlée est mis en œuvre par un système 1 d'irradiation tel qu'illustré à la figure 1. Un tel système comprend un dispositif émetteur 11, au moins un dispositif de mesure et d'analyse 12 et un dispositif contrôleur 13, lesquels fonctionnent en boucle fermée. De façon générale, le dispositif de mesure et d'analyse 12 mesure les données énergétiques réelles et analyse l'effet réel au niveau de la zone cible, lorsque le dispositif émetteur 11 irradie des rayonnements énergétiques au niveau de cette zone cible. Il transmet ensuite ces deux types de données au dispositif contrôleur 13, qui est alors capable de contrôler le dispositif émetteur 11 en modulant les paramètres énergétiques des rayonnements énergétiques émis par celui-ci, en prenant en compte les paramètres prédéterminés avec lesquels il a été chargé (seuils énergétiques et effet attendu) et les données réelles transmises par le dispositif de mesure et d'analyse 12. Dans le mode de réalisation de la figure 1, le dispositif émetteur 11 émet des radiations énergétiques R au niveau d'une zone cible C à irradier, appartenant à une surface S qui se compose d'une pluralité de zones S1, S2...Si...Sn. Dans d'autres modes de réalisation de l'invention, la zone cible peut correspondre à la combinaison de plusieurs zones de la pluralité de zones S1, S2...Si...Sn de la surface à irradier, et peut également correspondre à l'entièreté de la surface S, c'est-à-dire inclure l'ensemble de la pluralité de zones qui composent cette surface S. L'émission de rayonnement énergétiques R sur la zone cible C produit une énergie réelle E1C au niveau de cette zone cible, qui est mesurable par le procédé de l'invention.

Dans ce mode de réalisation, le dispositif émetteur 11 correspond à une matrice qui comprend une pluralité de sources émettrices indépendantes 111. Ces sources 111 peuvent être activées ou désactivées indépendamment les unes des autres par le dispositif contrôleur 13 du système, en fonction notamment de l'énergie réelle E1C mesurée au niveau de la zone cible C irradiée, ainsi que de l'effet réel A1C obtenu au niveau de cette zone, ces données réelles étant comparées à des données prédéterminées, correspondant à des seuils énergétiques prédéterminés et à l'effet final attendu au niveau de la surface à irradier. Selon un exemple, ces sources 111 indépendantes sont des LED.

Selon d'autres modes de réalisation, non illustrés, le dispositif émetteur 11 peut être une source mobile embarquée sur un axe XY(Z), apte à se déplacer le long de cet axe, ou encore une source positionnée d'une manière statique et réorientée vers la zone cible à irradier par un galvanomètre optique.

L'énergie réelle E1C et l'effet réel A1C au niveau de la zone cible C sont mesurés et analysés par le dispositif de mesure et d'analyse 12 du système. Pour cela, ce dispositif 12 comprend au moins un moyen de mesure et d'enregistrement M pour mesurer l'énergie réelle E1C au niveau de la zone cible C irradiée, ainsi qu'au moins un moyen d'analyse et d'enregistrement A pour analyser l'effet réel A1C au niveau de cette zone. Selon un exemple particulier, ce dispositif 12 correspond à une caméra qui comprend en tant que moyen de mesure et d'enregistrement M un dispositif thermique, pour mesurer la température au niveau de la zone cible irradiée, laquelle température correspond à l'énergie réelle E1C, et/ou un dispositif d'analyse de radiations, pour mesurer tout type de rayonnements énergétiques émis par le dispositif émetteur 11 au niveau de la zone cible irradiée. Toujours selon cet exemple particulier, le dispositif 12 comprend en outre en tant que moyen d'analyse et d'enregistrement A un dispositif d'analyse d'image, pour analyser l'effet réel A1C obtenu au niveau de la zone cible irradiée. Le dispositif de mesure et d'analyse 12 selon l'invention est dans tous les cas apte à enregistrer ces données d'énergie mesurée E1C et d'effet analysé A1C, et transmet ces deux types de données au dispositif contrôleur 13 du système.

Ce dispositif contrôleur 13 comprend donc les données réelles de la zone cible C irradiée, qu'il a reçu du dispositif de mesure et d'analyse 12, et il comprend en outre des données prédéterminées qui ont été chargées dans ce dispositif 13 au début du procédé d'irradiation, lesquelles données prédéterminées comprenant les seuils énergétiques principaux prédéterminés E2S1, E2S2...E2Si...E2Sn qui sont respectivement associés à chacune des zones S1, S2...Si...Sn de la surface S à irradier, ainsi qu'à l'effet cible O à obtenir. Dans le but de contrôler le dispositif émetteur 11 en temps réel, ce dispositif contrôleur 13 comprend des moyens de comparaison de la mesure de l'énergie réelle E1C au seuil énergétique principal prédéterminé E2C associé à la zone cible C, et des moyens de comparaison de l'analyse de l'effet réel A1C à l'effet cible O. Ainsi, le dispositif 13 est capable de contrôler le dispositif émetteur 11 en temps réel en opérant différentes actions, qui sont fonction de l'énergie réelle E1C et tout à la fois de l'effet réel A1C au niveau de la zone cible C. Notamment, selon un premier cas, si le dispositif contrôleur 13 détermine, par le biais de ses différents moyens de comparaison, que l'énergie réelle E1C de la zone cible C est inférieure au seuil énergétique principal prédéterminé E2C pour cette zone, et qu'à la fois l'effet réel A1C au niveau de cette zone ne correspond pas à l'effet cible O, il contrôle le dispositif émetteur 11 pour que celui-ci continue d'émettre des rayonnements énergétiques sur la zone cible, et il module la puissance et/ou l'intensité de ces rayonnements, jusqu'à ce que l'effet cible O soit obtenu.

Selon un deuxième cas, si le dispositif contrôleur 13 détermine, que l'énergie réelle E1C de la zone cible C correspond au seuil énergétique principal prédéterminé E2C pour cette zone, mais que l'effet réel A1C ne correspond pas à l'effet cible O, il contrôle le dispositif émetteur 11 pour que celui-ci continue d'émettre des rayonnements énergétiques sur la zone cible, et il module la puissance et/ou l'intensité de ces rayonnements, jusqu'à ce que l'effet cible O soit obtenu.

Selon un troisième cas, si le dispositif contrôleur 13 détermine que l'énergie réelle E1C de la zone cible C correspond au seuil énergétique principal prédéterminé E2C, et qu'à la fois l'effet réel A1C au niveau de cette zone correspond à l'effet cible O, il contrôle le dispositif émetteur 11 pour que celui-ci arrête l'émission des rayonnements énergétiques sur la zone cible O, puisque l'effet cible O est bien obtenu.

Enfin, selon un quatrième cas, si le dispositif contrôleur 13 détermine que l'énergie réelle E1C de la zone cible C est inférieure au seuil énergétique principal prédéterminé E2C, mais que l'effet réel A1C correspond à l'effet cible O, il contrôle le dispositif émetteur 11 pour que celui-ci arrête l'émission des rayonnements énergétiques sur la zone cible O, bien que le seuil énergétique principal prédéterminé E2C ne soit pas atteint, puisque les paramètres énergétiques réels des rayonnements R ont permis d'obtenir l'effet cible O.

Selon un mode de réalisation, ce dispositif contrôleur 13 est une interface Humain-Machine, qui peut par exemple être un ordinateur, une tablette ou un smartphone, ou encore un automate.

Le dispositif 13 permet ainsi un gain énergétique avantageux, puisqu'il est capable d'arrêter l'irradiation de la zone/surface cible lorsqu'il est déterminé que l'effet attendu est obtenu, indépendamment des seuils énergétiques de base rentrés dans le dispositif 13. L'émission de rayonnements inutiles est donc avantageusement limitée, dès que l'effet cible est obtenu, ce qui est pertinent d'un point de vue financier et environnemental Le dispositif 13 est également capable de contrôler de façon indépendante la pluralité de sources émettrices 111 du dispositif émetteur 11, en fonction de l'effet réel analysé au niveau de la zone cible C tout au long du processus d'irradiation, pour adapter cette zone cible. Par exemple, si le dispositif contrôleur 13 détermine que l'effet réel A1C au niveau de la zone cible C correspond à l'effet cible O sur une partie de cette zone cible, mais que cet effet cible O n'est pas encore obtenu sur la totalité de cette zone, il peut agir sur le dispositif émetteur 11 pour désactiver les LED 111 localisées au-dessus de la partie de la zone cible pour laquelle l'effet cible O est obtenu, et augmenter la puissance et/ou l'intensité énergétique des LED 111 localisées au-dessus de la partie de la zone cible pour laquelle l'effet cible O n'est pas encore obtenu. Ainsi, la zone cible C effectivement irradiée est réduite.

Selon l'invention, le dispositif de mesure et d'analyse 12 est également apte à mesurer l'énergie réelle collatérale E3 d'une ou plusieurs zones, par exemple d'une zone Si, qui est adjacente/collatérale à la zone cible irradiée C. Cette mesure est enregistrée au sein du dispositif 12, qui la transmet au dispositif de contrôle 13. Dans celui-ci, il a préalablement été rentré des seuils énergétiques secondaires E4S1, E4S2, E4Si...E4Sn, associés à chacune des zones constituant la surface S : le dispositif de contrôle 13 est alors en mesure de comparer l'énergie collatérale E3Si mesurée au niveau de la zone Si adjacente à la zone cible irradiée C au seuil énergétique secondaire E4Si de cette zone. En fonction du résultat de cette comparaison, il peut moduler la source émettrice 11 pour impacter dans un sens ou dans l'autre l'énergie réelle collatérale E4Si de cette zone adjacente à la zone irradiée C : il peut réduire la puissance et/ou l'intensité des rayonnements de la source 11, pour réduire cette énergie collatérale E3Si, s'il est déterminé qu'elle a atteint le seuil énergétique secondaire E4Si de cette zone, ou au contraire il peut augmenter la puissance et/ou l'intensité des rayonnements de la source 11, pour augmenter cette énergie collatérale E3Si, s'il est déterminé qu'elle n'a pas encore atteint le seuil énergétique secondaire E4Si de cette zone. Ainsi, l'interprétation des mesures issues de capteurs secondaires liés aux énergies générées collatéralement à la zone cible irradiée C permet de préserver l'intégrité de la cible.

On comprend donc que, selon l'invention, chacune des zones constituant la surface S à irradier est associée à deux types de seuils énergétiques prédéterminés, entrés dans le dispositif de contrôle 13 : des premiers seuils énergétiques prédéterminés E2, dits seuils énergétiques principaux, et des deuxièmes seuils énergétiques prédéterminés E4, dits seuils énergétiques secondaires.

Les rayonnements énergétiques R émis par le dispositif émetteur 11 peuvent être des radiations de lumière visible, infra-rouges, gamma, ultra-violette, laser, ou encore du déploiement thermique convectif ou conductif.

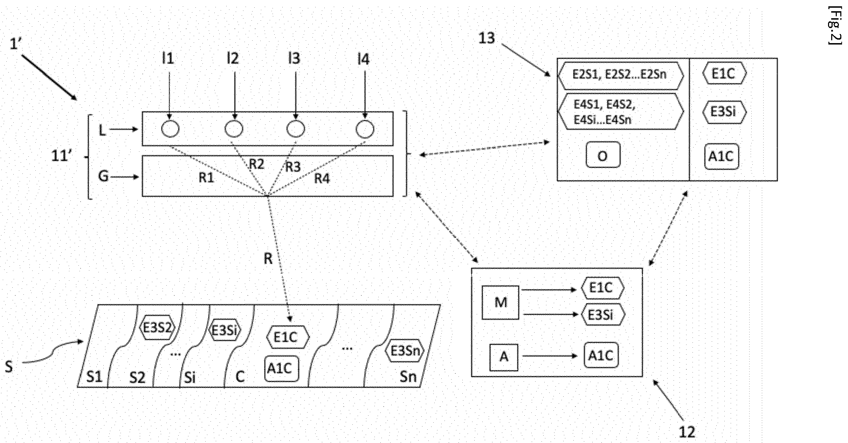

La figure 2 illustre un autre exemple du système 1' de l'invention, et qui correspond au système tel qu'illustré à la figure 1 dans lequel le dispositif émetteur 11' est constitué d'une matrice support L regroupant quatre sources laser I1, I2, I3 et I4, et d'un galvanomètre optique G. Ces quatre sources laser I1, I2, I3 et I4 émettent chacune respectivement un rayonnement énergétique R1, R2, R3 et R4. Ces quatre rayonnements R1, R2, R3 et R4 sont combinés en un unique rayonnement énergétique R par le galvanomètre optique G, ce rayonnement unique R étant dirigé vers la zone cible à irradier.

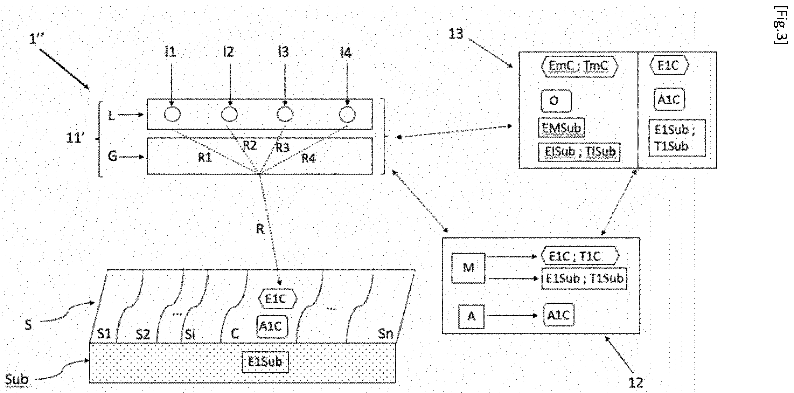

Selon un exemple particulier de réalisation de l'invention, illustré par le système 1" de la figure 3, la zone cible C à irradier correspond à une zone d'une surface S d'une couche d'une matière, laquelle couche de matière est déposée sur un substrat Sub, qui par exemple correspond à au moins une autre couche d'une autre matière, distincte de la matière à irradier. Le système 1" selon l'invention est alors apte à irradier de façon contrôlée la zone cible C de la surface de la couche de matière qui est exposée à l'air libre et qui est déposée sur le substrat Sub. Le système 1" est en outre apte à évaluer l'état du substrat Sub en fonction de la progression de l'irradiation de la couche de matière qui le recouvre. De préférence, cette évaluation de l'état du substrat Sub est réalisée simultanément à l'irradiation de la couche de matière qui le recouvre. Cela permet notamment de s'assurer que le substrat Sub n'est pas endommagé par l'irradiation de la couche de matière qui le recouvre, au moins partiellement.

Par exemple, l'évaluation de l'état du substrat Sub est mise en œuvre par le contrôle visuel de son état, par exemple son état de surface, et/ou par le contrôle de ses propriétés physico-chimiques, telle que sa température ou encore sa viscosité.

Par ailleurs, il est à noter que la matière déposée sur le substrat Sub est, de préférence, de l'encre liquide.

Ainsi, selon cet exemple particulier de l'invention, il est possible de saisir différents paramètres dans le dispositif contrôleur 13 du système, ou dans une unité d'enregistrement à laquelle le dispositif contrôleur 13 a accès. De préférence, un seuil énergétique principal prédéterminé EmC associé à la zone cible C à irradier y est saisi. Ce seuil énergétique principal prédéterminé correspond, de préférence, à un seuil énergétique minimal. En outre, l'effet cible O à obtenir par l'irradiation au niveau de cette zone cible C est, de préférence, également saisi dans l'unité d'enregistrement. Une durée prédéterminée TmC est également saisie dans le dispositif contrôleur 13, cette durée prédéterminée TmC étant associée au seuil énergétique minimal EmC de la zone cible C, et correspond de préférence à une durée seuil minimale.

Par exemple, le seuil énergétique minimal EmC correspond à une température seuil minimale, et l'effet cible O à obtenir correspond à la polymérisation de la matière de la zone cible C.

Ainsi, lorsque l'un des dispositifs émetteur 11 décrits dans les exemples présentés ci-avant dans la description, irradie la zone cible C, le dispositif de mesure et d'analyse 12 du système 1" de l'invention, qui est par exemple une caméra thermique, mesure l'énergie réelle E1C au niveau de cette zone cible C, c'est-à-dire qu'il mesure sa température réelle, pour s'assurer que celle-ci est égale ou sensiblement supérieure à la température seuil minimale prédéfinie EmC pour cette zone. Le dispositif de mesure et d'analyse 12 contrôle également la durée T1C pendant laquelle la zone cible C est irradiée à cette température seuil minimale EmC, pour s'assurer que la zone cible C est irradiée à la température seuil minimale EmC pendant la durée seuil minimale TmC prédéfinie pour cette zone. Le dispositif de mesure et d'analyse 12 contrôle en outre l'effet réel A1C obtenu au niveau de la zone irradiée, en vue de s'assurer que celui-ci correspond effectivement à l'effet cible O à obtenir préalablement saisi dans le dispositif contrôleur 13.

Par ailleurs, toujours selon cet exemple particulier de l'invention, un seuil énergétique maximal EMSub et un seuil énergétique intermédiaire ElSub sont, de préférence, en outre saisis dans le dispositif contrôleur 13, ces deux seuils étant associés au substrat Sub. Par exemple, ce seuil énergétique maximal EMSub et ce seuil énergétique intermédiaire ElSub correspondent respectivement à une température maximale et à une température intermédiaire que le substrat Sub est en capacité d'atteindre. De plus, une durée maximale TISub associée au seuil énergétique intermédiaire ElSub est de préférence également saisie dans le dispositif contrôleur 13.

Ainsi, parallèlement à l'analyse de la matière de la zone cible C irradiée, lorsque le dispositif émetteur 11' irradie la zone cible C, le dispositif de mesure et d'analyse 12 mesure l'énergie effective E1Sub au niveau du substrat Sub, c'est-à-dire qu'il mesure sa température réelle, pour déterminer que celle-ci ne dépasse pas la température seuil maximale EMSub prédéfinie pour ce substrat Sub. Également, le dispositif de mesure et d'analyse 12 détermine la durée T1Sub pendant laquelle le substrat Sub atteint la température seuil intermédiaire prédéfinie ElSub, pour vérifier que cette température intermédiaire n'est pas atteinte pendant une durée supérieure à la durée seuil maximale prédéfinie TISub.

Le dispositif de mesure et d'analyse 12 transmet l'ensemble des données mesurées et enregistrées, associées à la zone cible C de la matière à irradier et au substrat Sub, au dispositif contrôleur 13. Ce dernier est alors en mesure d'adapter l'orientation et/ou la puissance et/ou l'intensité du dispositif émetteur 11', afin de polymériser la zone cible C sans endommager le substrat Sub.

Ci-après sont présentés plusieurs exemples de mise en œuvre du procédé et du système d'irradiation selon l'invention pour différentes applications. Il est entendu que ces exemples ne sont pas limitatifs, et que l'invention peut être mise en œuvre pour tout type d'application impliquant l'irradiation énergétique d'une surface pour obtenir un effet donné.

### Premier exemple de réalisation

Le procédé selon l'invention peut être mis en œuvre dans le cas de l'application d'une couche de vernis adapté sur une zone cible C, laquelle peut correspondre à un ou plusieurs ongles d'une main et/ou d'un pied, dans le but d'obtenir un effet cible O qui correspond à la solidification de la couche de vernis, par un processus de polymérisation par irradiation. Dans ce premier exemple, le dispositif émetteur 11 est une lampe qui émet des rayonnements ultra-violets (UV) vers la zone cible C qui correspond à un ou plusieurs ongles recouverts d'une couche de vernis, et qui est constituée d'une multitude de LED UV 111.

Le dispositif de mesure et d'analyse 12 est une sonde radiation UV doublée d'une caméra thermique, qui comprend un module de mesure de la dose UV et de la température réelle E1C au niveau de la surface du ou des ongles irradiés recouverts de vernis, et un module d'analyse visuelle de l'état de la polymérisation A1C de la couche de vernis au niveau de cette zone.

Le dispositif contrôleur 13, quant à lui, est un ordinateur, dans lequel il a été rentré la température prédéterminée E2C qui permet a priori d'obtenir la polymérisation totale de la couche de vernis sur la zone cible C, ainsi que l'état visuel cible O de la polymérisation finale de la couche de vernis au niveau de cette zone. Cet ordinateur 13 comprend également des moyens de comparaison des données de température réelles E1C par rapport aux données de température prédéterminées E2C pour la zone cible C à irradier, ainsi des moyens de comparaison de l'état réel A1C de la polymérisation de la couche de vernis par rapport à l'état attendu O de polymérisation pour cette zone.

Dans cet exemple d'application de l'invention, la lampe UV 11 émet des radiations UV vers la zone cible C déterminée. La caméra thermique associée à la sonde UV 12 mesure alors la température réelle E1C de la zone cible C, et analyse l'état réel A1C de la polymérisation de la couche de vernis au niveau de cette zone. Il enregistre ces deux types d'informations, et les transmet à l'ordinateur 13 de contrôle. Ce dernier est alors capable de déterminer, grâce à ses moyens de comparaison, si la couche de vernis de la zone cible a été polymérisée sur l'entièreté de la zone, ou si une ou plusieurs portions de cette zone nécessitent encore une irradiation pour obtenir l'effet final attendu O. Il est donc capable d'augmenter la puissance et/ou l'intensité des LED UV 111 de la lampe 11, voir d'activer des LED qui seraient éteinte, et qui sont positionnées au-dessus de la ou des portions de la zone cible pour lesquelles la couche de vernis n'est pas encore totalement polymérisée, et à l'inverse, de réduire la puissance et/ou l'intensité des LED UV 111, voir de désactiver certaines LED, qui sont positionnées au-dessus de la ou des portions de la zone cible pour lesquelles la couche de vernis a été totalement polymérisée ou au-dessus de zones d'épiderme.

En outre, selon un mode de réalisation particulier de cet exemple, la caméra thermique associée à la sonde UV 12 est capable de mesurer et d'enregistrer l'énergie réelle collatérale de zones autour de l'ongle cible, correspondant notamment à des zones de peau autour de l'ongle. Ces données sont transmises à l'ordinateur de contrôle 13, qui les compare alors aux données seuils énergétiques secondaires associées à ces zones de peau. Si l'ordinateur 13 détermine, à l'issu de cette étape de comparaison, que l'énergie collatérale effective dans ces zones de peau a atteint les seuils secondaires correspondant, il module alors la puissance et/ou l'intensité des LED UV 111 au-dessus de la zone ongle irradiée pour réduire l'énergie ressentie au niveau collatéral, sur les zones de peau. Ainsi, grâce à la vision thermique, la radiation UV adjacente à la zone cible C est maitrisée, évitant de potentielles brulures locales.

Ainsi, le procédé et le système d'irradiation selon l'invention permettent avantageusement un gain énergétique substantiel dans le domaine de la cosmétique, en particulier de l'onglerie, car le contrôle des dispositifs émetteurs 11 utilisés pour polymériser les couches de vernis sur les ongles peut être adapté à la demande en boucle fermée, en fonction de l'évolution de la situation réelle. Il permet également de minimiser les risques de cancer de la peau liés à l'exposition UV et les risque de brulure liés à la radiation UV ou IR adjacente.

### Deuxième exemple de réalisation

Le procédé selon l'invention peut également être mis en œuvre dans le cas de la fabrication d'une pièce par une méthode de fabrication additive, par exemple pour fabriquer des semi-conducteurs dans le domaine de la micro-électronique. Une telle pièce notamment produite par solidification de la ou des couches de matière ajoutées selon la technique de fabrication additive, par polymérisation par irradiation.

Dans ce deuxième exemple, le système d'irradiation en boucle fermée comprend un dispositif émetteur 11 qui est une source qui émet des rayonnements laser vers la zone cible C, laquelle correspond à une ou plusieurs zones d'une couche de matière déposée par fabrication additive, cette source 11 étant constituée d'une multitude de sources laser 111. Il comprend également un dispositif de mesure et d'analyse 12, qui est une caméra thermique telle que décrite en détails dans le premier exemple ci-avant. Et il comprend en outre un dispositif contrôleur 13, qui est un ordinateur tel que décrit également dans le premier exemple ci-avant.

Dans cet exemple d'application de l'invention, le procédé d'irradiation comprend les mêmes étapes que le procédé d'irradiation de l'exemple précédent. Ce sont les sources lasers 111 du dispositif émetteur 11 qui sont contrôlées (activées, désactivées, modulation de leur puissance et/ou de leur intensité) par l'ordinateur 13 de contrôle, en fonction de la température prédéterminée E2C apte à polymériser complètement la zone cible, et de l'état visuel attendu O correspondant à la polymérisation complète de cette zone, tout à la fois en prenant en compte la température réelle E1C mesurée au niveau de cette zone cible et l'état réel de la polymérisation au niveau de cette zone. Le dispositif de contrôle 13 permet donc de gérer la source laser 11 pour que l'émission de radiations laser R inutiles, car localisées au niveau d'une partie de la zone cible totalement polymérisée, soit limitée, voir arrêtée.

Ce système d'irradiation, dans ce cas d'application au domaine de la fabrication additive, peut également être en mesure de mesurer et d'analyser l'énergie collatérale autour de la zone cible en fabrication, par rapport à des données seuils énergétiques secondaires associées aux zones adjacentes à cette zone cible.

Un gain énergétique et financier non négligeable peut être obtenu dans le domaine de la fabrication additive. Le contrôle sélectif de la radiation permet également de minimiser la montée en température globale de la cible. Cela présente un impact direct sur l'intégrité du module semi-conducteur, et ouvre un panel de produits potentiellement éco-responsables pour la fabrication de ces semi-conducteurs.

## Revendications

1. Procédé d'irradiation sélective contrôlée d'une zone cible (C) d'une surface (S) d'une couche de matière, telle qu'une couche de vernis ou une couche d'une matière d'un semi-conducteur, pour permettre la radiation locale de ladite zone cible (C) en vue d'obtenir un effet cible (O), consistant en la polymérisation de la couche de matière,
ledit procédé étant mis en œuvre par un système (1) comprenant un dispositif émetteur (11), au moins un dispositif de mesure et d'analyse (12) et un dispositif contrôleur (13),
ledit procédé comprenant les étapes suivantes :
A) segmentation de ladite surface (S) en une pluralité de zones (S1, S2...Sn) ;
B) entrée dans ledit dispositif contrôleur (13) de seuils énergétiques principaux prédéterminés (E2S1, E2S2...E2Sn) respectivement associés à chacune desdites zones (S1, S2...Sn) et entrée dudit effet cible (O) à obtenir ;
C) choix de ladite zone cible (C) parmi lesdites zones (S1, S2...Sn) et leurs combinaisons ;
D) irradiation de ladite zone cible (C) par émission de rayonnements énergétiques (R) par ledit dispositif émetteur (11), ladite émission étant contrôlée par ledit dispositif contrôleur (13) dans le but d'atteindre lesdits seuils énergétiques principaux prédéterminés (E2S1, E2S2...E2Sn) ;
E) mesure et enregistrement en temps réel, par ledit dispositif de mesure et d'analyse (12), de l'énergie réelle (E1C) générée par les rayonnements énergétiques (R) au niveau de ladite zone cible (C) ;
F) analyse et enregistrement, par ledit dispositif de mesure et d'analyse (12), de l'effet réel (A1C) obtenu au niveau de ladite zone cible (C) irradiée ;
G) transmission de la mesure de ladite énergie réelle (E1C) et de l'analyse dudit effet réel (A1C) audit dispositif contrôleur (13) ;
H) contrôle en temps réel dudit dispositif émetteur (11) par ledit dispositif contrôleur (13) au cours du procédé d'irradiation, en prenant en compte ladite mesure de l'énergie réelle (E1C) et ladite analyse de l'effet réel (A1C) reçues, ladite mesure d'énergie réelle (E1C) étant comparée au seuil énergétique principal prédéterminé (E2C) associé à ladite zone cible (C), et ladite analyse de l'effet réel (A1C) étant comparée audit effet cible (O), de manière à ce que :
- H1) si ledit seuil énergétique principal (E2C) n'est pas atteint et ledit effet cible (O) n'est pas obtenu, l'émission de rayonnements énergétiques (R) sur ladite zone cible (C) continue et la puissance et/ou l'intensité desdits rayonnements énergétiques (R) sont modulées pour obtenir ledit effet cible (O) ;
- H2) si ledit seuil énergétique principal (E2C) est atteint mais ledit effet cible (O) n'est pas obtenu, l'émission de rayonnements énergétiques (R) sur ladite zone cible (C) continue et la puissance et/ou l'intensité desdits rayonnements énergétiques (R) sont modulées pour obtenir ledit effet cible (O) ;
- H3) si ledit seuil énergétique principal (E2C) est atteint et ledit effet cible (O) est obtenu, l'émission de rayonnements énergétiques (R) sur ladite zone cible (C) est stoppée ;
- H4) si ledit seuil énergétique principal (E2C) n'est pas atteint mais ledit effet cible (O) est obtenu, l'émission de rayonnements énergétiques (R) sur ladite zone cible (C) est stoppée.

2. Procédé selon la revendication 1, comprenant en outre les étapes suivantes :
A') entrée dans ledit dispositif contrôleur (13) de seuils énergétiques secondaires prédéterminés (E4S1, E4S2, E4Si...E4Sn) respectivement associés à chacune desdites zones (S1, S2...Sn) ;
B') mesure et enregistrement en temps réel, par ledit dispositif de mesure et d'analyse (12), de l'énergie réelle collatérale (E3Si), générée au niveau d'au moins une zone (Si) de ladite pluralité de zones (S1, S2...Sn) qui est adjacente à ladite zone cible (C), ladite énergie réelle collatérale (E3Si) étant générée par les rayonnements énergétiques (R) irradiant ladite zone cible (C) ;
C') transmission de la mesure de ladite énergie réelle collatérale (E3Si) audit dispositif contrôleur (13) ;
D') contrôle en temps réel dudit dispositif émetteur (11) par ledit dispositif contrôleur (13) au cours du procédé d'irradiation, en prenant en compte la mesure de ladite énergie réelle collatérale (E3Si),
la mesure de ladite énergie réelle collatérale (E3Si) étant comparée au seuil énergétique secondaire prédéterminé (E4Si) associé à l'au moins une zone (Si) de ladite pluralité de zones (S1, S2...Sn) qui est adjacente à ladite zone cible (C), de manière à ce que :
si ledit seuil énergétique secondaire (E4Si) de ladite au moins une zone (Si) adjacente à ladite zone cible (C) est atteint, la puissance et/ou l'intensité desdits rayonnements énergétiques (R) irradiant ladite zone cible (C) sont modulées pour réduire ladite énergie réelle collatérale (E3Si).

3. Procédé selon la revendication 1 ou 2, comprenant en outre les étapes suivantes, lorsque ladite couche de matière est déposée sur un substrat (Sub) :
I) entrée dans ledit dispositif contrôleur (13) d'un seuil énergétique maximal (EMSub) associé audit substrat (Sub);
J) mesure et enregistrement en temps réel, par ledit dispositif de mesure et d'analyse (12), de l'énergie effective (E1Sub) générée au niveau dudit substrat (Sub);
K) transmission de la mesure de ladite énergie effective (E1Sub) audit dispositif contrôleur (13) ;
L) contrôle en temps réel dudit dispositif émetteur (11) par ledit dispositif contrôleur (13) au cours du procédé d'irradiation, en prenant en compte la mesure de ladite énergie effective (E1Sub),
la mesure de ladite énergie effective (E1Sub) étant comparée audit seuil énergétique maximal (EMSub), de manière à ce que, si ladite énergie effective (E1Sub) est supérieure audit seuil énergétique maximal (EMSub), la puissance et/ou l'intensité desdits rayonnements énergétiques (R) irradiant ladite zone cible (C) sont modulées pour réduire ladite énergie effective (E1Sub) au niveau dudit substrat.

4. Procédé selon la revendication 3, comprenant en outre les étapes suivantes :
l') entrée dans ledit dispositif contrôleur (13) d'un seuil énergétique intermédiaire (EISub) associé audit substrat (Sub), ainsi que d'une durée maximale (TISub) associée audit seuil énergétique intermédiaire (EISub) ;
M) contrôle en temps réel dudit dispositif émetteur (11) par ledit dispositif contrôleur (13) au cours du procédé d'irradiation, en prenant en compte la mesure de ladite énergie effective (E1Sub),
la mesure de ladite énergie effective (E1Sub) étant comparée au seuil énergétique intermédiaire (EISub), et lorsque ladite énergie effective (E1Sub) correspond audit seuil énergétique intermédiaire (EISub), ledit dispositif de mesure et d'analyse (12) mesure et enregistre en temps réel une durée effective (T1Sub) correspondant à la durée pendant laquelle ladite énergie effective (E1Sub) correspond audit seuil énergétique intermédiaire (EISub), et ledit dispositif contrôleur compare ladite durée effective (E1Sub) à ladite durée maximale (TISub), de manière à ce que, si ladite durée effective (T1Sub) est supérieure à ladite durée maximale (TISub), la puissance et/ou l'intensité desdits rayonnements énergétiques (R) irradiant ladite zone cible (C) sont modulées pour réduire ladite énergie effective (E1Sub) au niveau dudit substrat.

5. Procédé selon l'une quelconque des revendications 1 à 4, dans lequel ladite zone cible (C) correspond à la totalité de la surface (S).

6. Procédé selon l'une quelconque des revendications 1 à 5, dans lequel ledit dispositif émetteur (11) est fixe et choisi parmi une matrice comprenant une pluralité de sources émettrices (111) indépendantes et au moins une source émettrice associée à un galvanomètre optique.

7. Procédé selon la revendication 6, dans lequel, lorsque ledit dispositif émetteur (11) est une matrice comprenant une pluralité de sources émettrices (111) indépendantes, lesdites sources émettrices (111) indépendantes sont des LED.

8. Procédé selon l'une quelconque des revendications 1 à 5, dans lequel ledit dispositif émetteur (11) est mobile, tel qu'une source mobile embarquée sur un axe.

9. Procédé selon l'une quelconque des revendication 1 à 8, dans lequel ledit dispositif de mesure et d'analyse (12) est un capteur d'imagerie thermique et/ou radiatif, associé à un module d'analyse d'image.

10. Procédé selon l'une quelconque des revendication 1 à 9, dans lequel ledit dispositif contrôleur (13) est une interface Homme-Machine.

11. Procédé selon l'une quelconque des revendication 1 à 10, dans lequel lesdites radiations énergétiques (R) sont choisies parmi les radiations de lumière visible, infra-rouges, gamma, ultra-violettes, laser, les micro-ondes, les rayons X et le déploiement thermique convectif ou conductif.

12. Système (1) d'irradiation sélective contrôlée d'une zone cible (C) d'une surface (S) d'une couche de matière, telle qu'une couche de vernis ou une couche d'une matière d'un semi-conducteur, ladite surface (S) étant segmentée en une pluralité de zones (S1, S2, Si...Sn), ledit système (1) mettant en œuvre le procédé selon l'une quelconque des revendications 1 à 11, comprenant :
- un dispositif émetteur (11), configuré pour irradier ladite zone cible (C) par des rayonnements énergétiques (R),
- au moins un dispositif de mesure et d'analyse (12), configuré pour mesurer l'énergie réelle (E1C) générée par les rayonnements énergétiques (R) au niveau de ladite zone cible (C) et l'énergie réelle collatérale (E3Si) générée au niveau d'au moins une zone (Si) de ladite pluralité de zones (S1, S2...Sn) qui est adjacente à ladite zone cible (C), ainsi que pour analyser l'effet réel (A1C) obtenu au niveau de ladite zone cible (C) irradiée,
- un dispositif contrôleur (13), configuré pour recevoir des seuils énergétiques prédéterminés principaux (E2S1, E2S2...E2Sn) et secondaires (E4S1, E4S2, E4Si...E4Sn) respectivement associés à chacune desdites zones (S1, S2...Sn) et un effet cible (O) à obtenir, ainsi que pour recevoir la mesure de ladite énergie réelle (E1C) et de ladite l'énergie réelle collatérale (E3Si), ainsi que l'analyse dudit effet réel (A1C),
ledit dispositif contrôleur (13) comprenant des moyens de comparaison de ladite mesure d'énergie réelle (E1C) au seuil énergétique principal prédéterminé (E2C) associé à ladite zone cible (C), de ladite mesure de l'énergie réelle collatérale (E3Si) au seuil énergétique prédéterminé secondaire (E4Si) de l'au moins une zone (Si) adjacente à ladite zone cible (C), et de ladite analyse de l'effet réel (A1C) audit effet cible (O),
ledit dispositif contrôleur (13) étant en outre configuré pour contrôler ledit dispositif émetteur (11) en temps réel au cours du procédé d'irradiation par arrêt de l'émission desdits rayonnements énergétiques (R), et/ou par modulation de la puissance et/ou l'intensité desdits rayonnements énergétiques (R), et/ou par modulation sélective des zones irradiées.

13. Système selon la revendication 12, dans lequel ledit dispositif de mesure et d'analyse (12) est en outre configuré pour mesurer l'énergie effective (E1Sub) au niveau d'un substrat (Sub) sur lequel ladite couche de matière a été déposée, et dans lequel ledit dispositif contrôleur (13) est en outre configuré pour recevoir un seuil énergétique maximal (EMSub) associé audit substrat (Sub), ledit dispositif contrôleur (13) comprenant en outre des moyens de comparaison de ladite mesure d'énergie effective (E1Sub) audit seuil énergétique maximal (EMSub).

14. Système selon la revendication 13, dans lequel ledit dispositif contrôleur (13) est en outre configuré pour recevoir un seuil énergétique intermédiaire (EISub) associé audit substrat (Sub) et une durée maximale (TISub) associée audit seuil énergétique intermédiaire (EISub), ledit dispositif contrôleur (13) comprenant en outre des moyens de comparaison de ladite mesure d'énergie effective (E1Sub) audit seuil énergétique intermédiaire (EISub), et dans lequel, lorsque ladite énergie effective (E1Sub) correspond audit seuil énergétique intermédiaire (EISub), ledit dispositif de mesure et d'analyse (12) est en outre configuré pour mesurer la durée effective (T1Sub) pendant laquelle ladite énergie effective (E1Sub) correspond audit seuil énergétique intermédiaire (EISub), et ledit dispositif contrôleur (13) comprenant en outre des moyens de comparaison de ladite durée effective (T1Sub) à ladite durée maximale (TISub) d'irradiation.

15. Système selon l'une quelconque des revendications 12 à 14, dans lequel ledit dispositif de mesure et d'analyse (12) comprend :
- au moins un moyen de mesure et d'enregistrement (M) configuré pour mesurer ladite énergie réelle (E1C) générée par les rayonnements énergétiques (R) au niveau de ladite zone cible (C) et ladite énergie réelle collatérale (E3Si) au niveau d'au moins une zone (Si) adjacente à ladite zone cible (C), et, lorsque ledit dispositif de mesure et d'analyse (12) est en outre configuré pour mesurer l'énergie effective (E1Sub) au niveau du substrat (Sub), ledit moyen de mesure et d'enregistrement (M) est en outre configuré pour mesurer ladite énergie effective (E1Sub) et ladite durée effective (T1Sub) au niveau dudit substrat (Sub), et
- au moins un moyen d'analyse et d'enregistrement (A) configuré pour analyser ledit effet réel (A1C) obtenu au niveau de ladite zone cible (C) irradiée.

## Patentansprüche

1. Verfahren zur kontrollierten selektiven Bestrahlung eines Zielbereichs (C) einer Oberfläche (S) einer Materialschicht, wie beispielsweise einer Lackschicht oder einer Schicht aus einem Halbleitermaterial, um eine lokale Bestrahlung des Bereichs zu ermöglichen
(C) um eine Zielwirkung (0) zu erzielen, die in der Polymerisation des Materialschicht,
wobei das Verfahren von einem System (1) ausgeführt wird, das eine Sendevorrichtung (11), mindestens eine Mess- und Analysevorrichtung (12) und eine Steuereinrichtung (13) umfasst,
Das Verfahren umfasst die folgenden Schritte:
A) Segmentierung der genannten Oberfläche (S) in mehrere Zonen (S1, S2... Sn);
B) Eingabe von vorgegebenen Hauptenergieschwellen ( E2S1, E2S2... E2Sn), die jeweils mit jeder der genannten Zonen (S1, S2... Sn) und geben Sie den zu erhaltenden Zieleffekt (0) ein ;
C) Auswahl des Zielbereichs (C) aus den genannten Bereichen (S1, S2... Sn) und deren Kombinationen;
D) Bestrahlung der Zielzone (C) durch Emission energiereicher Strahlung (R) durch die emittierende Vorrichtung (11), wobei die Emission durch die Steuervorrichtung (13) zum Zwecke des Erreichens der Energieschwellen gesteuert wird
vorgegebene Prinzipale (E2S1, E2S2... E2Sn);
E) Echtzeitmessung und -aufzeichnung der durch energetische Strahlung erzeugten tatsächlichen Energie (EIC) durch die Mess- und Analysevorrichtung (12)
(R) in dem Zielbereich (C);
F) Analyse und Aufzeichnung durch die Mess- und Analysevorrichtung (12)
die tatsächliche Wirkung (Ale), die auf der Ebene des bestrahlten Zielbereichs (C) erzielt wird;
G) Übertragung der Messung der Wirkenergie (EIC) und der Analyse der tatsächlichen Wirkung (Ale) an die Steuereinrichtung (13);
**H)** Echtzeitsteuerung der Sendeeinrichtung (11) durch die Steuereinrichtung (13) während des Bestrahlungsprozesses unter Berücksichtigung der
Messung der tatsächlichen Energie (EIC) und der erhaltenen Ist-Wirkungsanalyse (Ale),
wobei die tatsächliche Energiemessung (ELC) mit der vorgegebenen Hauptenergieschwelle (E2C) verglichen wird, die mit dem Zielbereich (C) verbunden ist, und die Analyse des wahren Effekts (Ale) mit dem Zieleffekt (0) verglichen wird, so dass:
- HI) wenn die Hauptenergieschwelle (E2C) nicht erreicht wird und der genannte Zieleffekt (0)
nicht erreicht wird, wird die Emission von energiereicher Strahlung (R) über den Zielbereich
(C) kontinuierlich und die Leistung und/oder Intensität der energetischen Strahlung (R) moduliert werden, um den Zieleffekt (0) zu erreichen;
- H2) wenn die Hauptenergieschwelle (E2C) erreicht wird, aber die Zielwirkung (0) nicht erreicht wird, die Emission der energiereichen Strahlung (R) auf der Zielfläche
(C) kontinuierlich und die Leistung und/oder Intensität der energetischen Strahlung (R) moduliert werden, um den Zieleffekt (0) zu erreichen;
- H3) wenn die Hauptenergieschwelle (E2C) erreicht und die Zielwirkung (0) erreicht wird, wird die Emission von energiereicher Strahlung (R) auf den Zielbereich (C) gestoppt;
- H4) wenn die genannte Hauptenergieschwelle (E2C) nicht erreicht wird, aber die angestrebte Wirkung
(0) erhalten wird, wird die Emission von energetischer Strahlung (R) über den Zielbereich
(C) gestoppt wird.

2. Verfahren nach Anspruch 1, das ferner folgende Schritte umfasst:
A') Eingabe von Sekundärenergieschwellen in die Steuereinrichtung (13) vorgegeben (E4SI, E4S2, E4Si... E4Sn) bzw. zugehörig bei jede der genannten Zonen (SI, S2... Sn);
B') Messung und Aufzeichnung der realen Kollateralenergie (E3Si), die auf der Ebene mindestens einer Zone (Si) der Mehrzahl von Zonen (SI, S2 ... Sn), das an das genannte Gebiet angrenzt
Ziel (C), wobei die tatsächliche Kollateralenergie (E3Si) durch Strahlung erzeugt wird (R) Bestrahlung des Zielbereichs (C);
C') Übertragung der Messung der realen Kollateralenergie (E3Si) an die Steuereinrichtung (13);
d) Echtzeitsteuerung der Sendeeinrichtung (11) durch die Vorrichtung Regler (13) während des Bestrahlungsprozesses unter Berücksichtigung der Messung der tatsächlichen Begleitenergie (E3Si),
die Messung der realen Kollateralenergie (E3Si) wird mit der vorgegebenen Sekundärenergieschwelle (E4Si) verglichen, die mit mindestens einer Zone (Si) der Mehrzahl von Zonen (SI, S2... Sn), das an den Zielbereich (C) angrenzt,
Weise bei was:
Wenn die Sekundärenergieschwelle (E4Si) des mindestens einen Bereichs (Si), der an den Zielbereich (C) angrenzt, erreicht wird, muss die Leistung und/oder Intensität der energetischen Strahlung (R), die den Zielbereich (C) abstrahlt, moduliert werden, um die tatsächliche Kollateralenergie (E3Si) zu reduzieren.

3. Verfahren nach Anspruch 1 oder 2, das ferner die folgenden Schritte umfasst, wenn die Materialschicht auf einem Substrat (sub) abgeschieden wird:
**(1)** Eingabe einer maximalen Energieschwelle (EMSub) in die Steuervorrichtung (13), die dem Substrat (Sub) zugeordnet ist;
J) Messung und Aufzeichnung in Echtzeit durch das Messgerät und Analyse (12) der effektiven Energie (EISub), die auf dem Substrat (Sub) erzeugt wird;
(K) Übertragung der Messung der Wirkenergie (EISub) an den Regler (13);
(L) Echtzeitsteuerung der Sendevorrichtung (11) durch die Vorrichtung Regler (13) während des Bestrahlungsprozesses unter Berücksichtigung der Messung der Wirkenergie (EISub),
wobei die Messung der Wirkenergie (EISub) mit der maximalen Energieschwelle (EMSub) verglichen wird, so dass, wenn die Wirkenergie (EISub) über der maximalen Energieschwelle (EMSub), Leistung und/oder Die Intensität der energiereichen Strahlung (R), die den Zielbereich (C) abstrahlt, wird moduliert, um die effektive Energie (EISub) auf dem Niveau des Substrats zu reduzieren.

4. Verfahren nach Anspruch 3, das ferner folgende Schritte umfasst:
I) Eingabe einer mittleren Energieschwelle in die Steuereinrichtung (13) (EISub), die mit dem Substrat (Sub) verbunden ist, sowie eine maximale Dauer (TISub) verbunden mit der genannten Zwischenenergieschwelle (EISub);
(M) Echtzeitsteuerung der Sendevorrichtung (11) durch die Steuereinrichtung (13) während des Bestrahlungsprozesses unter Berücksichtigung der Messung der Wirkenergie (EISub),
wobei die Messung der Wirkenergie (EISub) mit der Zwischenenergieschwelle (EISub) verglichen wird, und wobei die Wirkenergie (EISub) der Zwischenenergieschwelle (EISub) entspricht, misst und zeichnet die Mess- und Analysevorrichtung (12) in Echtzeit eine Wirkzeit (TISub) auf, die der
die Zeitspanne, in der die Wirkenergie (EISub) dem Schwellenwert entspricht (EISub), und die Prüfvorrichtung vergleicht die effektive Zeit (EISub) mit der maximalen Dauer (TISub), so dass, wenn die effektive Zeit (TISub) größer als die maximale Dauer (TISub) ist, die Leistung und/oder Intensität der energiereichen Strahlung (R), die den Zielbereich (C) werden moduliert, um die effektive Energie (EISub) auf dem Substrat zu reduzieren.

5. Verfahren nach einem der Ansprüche 1 bis 4, wobei der Bereich
Ziel (C) ist die gesamte Fläche (S).

6. Verfahren nach einem der Ansprüche 1 bei 5, wobei die emittierende Vorrichtung (11) fixiert und aus einer Matrix ausgewählt ist, die eine Vielzahl unabhängiger emittierender Quellen (111) und mindestens eine zugeordnete emittierende Quelle umfasst bei ein optisches Galvanometer.

7. Verfahren nach Anspruch 6, wobei die Sendevorrichtung (11)
ist eine Matrix, die eine Vielzahl von unabhängigen emittierenden Quellen (111) umfasst, wobei die unabhängigen emittierenden Quellen (111) LEDs sind.

8. Verfahren nach einem der Ansprüche 1 bis 5, wobei die Sendevorrichtung (11) beweglich ist, wie beispielsweise eine bewegliche Quelle, die in eine Achse eingebettet ist.

9. Verfahren nach einem der Ansprüche 1 bis 8, wobei die Vorrichtung Mess- und Analysesensor (12) ist ein Wärmebild- und/oder Strahlungssensor, der bei ein Bildanalysemodul.

10. Verfahren nach einem der Ansprüche 1 bis 9, wobei die Steuervorrichtung (13) eine Mensch-Maschine-Schnittstelle ist.

11. Verfahren nach einem der Ansprüche 1 bis 10, wobei
Die energetische Strahlung (R) wird aus sichtbarer, infraroter, gamma-, ultravioletter, Laser-, Mikrowellen-, Röntgen- und konvektiver oder leitfähiger thermischer Entfaltung ausgewählt.

12. System (1) zur kontrollierten selektiven Bestrahlung eines Zielbereichs (C) einer Oberfläche (S) einer Materialschicht, wie beispielsweise einer Lackschicht oder einer Schicht eines Materials
eines Halbleiters, wobei die Oberfläche (S) in eine Vielzahl von Zonen (SI, S2, Si... Sn), wobei das System (1) das Verfahren nach einem der Ansprüche 1 implementiert bei 11, darunter:
- eine Sendevorrichtung (11), die so konfiguriert ist, dass sie den Zielbereich (C) mit energiereicher Strahlung (R) bestrahlt,
- mindestens ein Mess- und Analysegerät (12), konfiguriert für die Messung der tatsächlichen Energie (EIC), die durch energetische Strahlung (R) erzeugt wird, auf dem Niveau von
die Zielzone (C) und die reale Kollateralenergie (E3Si), die auf der Ebene mindestens einer Zone (Si) der Mehrzahl von Zonen (SI, S2... Sn), die an das Zielgebiet (C) angrenzt, sowie zur Analyse der tatsächlichen Wirkung (Ale), die auf der Ebene des Zielbereichs erzielt wird
bestrahltes Ziel (C),
- ein Steuergerät (13), das so konfiguriert ist, dass es vorgegebene Hauptenergieschwellenwerte (E2SI, E2S2... E2Sn) und sekundär (E4SI, E4S2, E4Si... E4Sn), die jeweils mit jeder der genannten Zonen (SI, S2... Sn) und eine Zielwirkung (0) zu erhalten, sowie die Messung der tatsächlichen Energie (EIC) zu erhalten und
die reale Kollateralenergie (E3Si) sowie die Analyse des realen Effekts (Ale), die Steuervorrichtung (13) umfassend Mittel zum Vergleichen der tatsächlichen Energiemessung (EIC) bei der vorgegebenen Primärenergieschwelle (E2C), die der Zielzone (C) zugeordnet ist, von der tatsächlichen Sicherheitenenergiemessung (E3Si) mit der sekundären vorgegebenen Energieschwelle (E4Si) von mindestens einer Zone (Si) Angrenzend bei der Zielbereich (C) und die Analyse der tatsächlichen Wirkung (Ale) die Zielwirkung (0),
die Steuervorrichtung (13) weiterhin so konfiguriert ist, dass sie die Sendevorrichtung (11) in Echtzeit während des Bestrahlungsprozesses steuert, indem die Emission der energetischen Strahlung (R) gestoppt wird, und/oder durch Leistungsmodulation und/oder
die Intensität der besagten energiereichen Strahlung (R) und/oder durch selektive Modulation der bestrahlten Bereiche.

13. System nach Anspruch 12, wobei die Mess- und Analysevorrichtung (12) ferner dazu ausgebildet ist, die effektive Energie (EISub) an einem Substrat (Sub) zu messen, auf dem die Materialschicht abgeschieden wurde, und wobei die Steuervorrichtung (13) ferner so konfiguriert ist, dass sie eine maximale Energieschwelle (EMSub), die mit dem Substrat (Sub) verbunden ist, wobei die Steuervorrichtung (13) auch Mittel zum Vergleich der effektiven Energiemessung (EISub) mit der maximalen Energieschwelle (EMSub) umfasst.

14. System nach Anspruch 13, wobei die Steuervorrichtung (13) zusätzlich konfiguriert für den Empfang eines zugeordneten Zwischenenergieschwellenwerts (EISub) Substrat-Audit (Sub) und eine maximale Dauer (TISub), die mit dem Energieschwellenwert verbunden ist (EISub), wobei die Steuereinrichtung (13) ferner Mittel zum Vergleich der Effektivenergiemessung (EISub) der Zwischenenergieschwelle (EISub) umfasst, und wobei die Wirkenergie
(EISub) der genannten mittleren Energieschwelle (EISub) entspricht,
Die Messung und Analyse (12) ist ferner so konfiguriert, dass sie die effektive Zeit (TISub) misst, während der die effektive Energie (EISub) der mittleren Energieschwelle (EISub) entspricht, und die Steuervorrichtung (13) umfasst ferner Mittel zum Vergleichen der effektiven Zeit (TISub) mit der Dauer Maximum (TISub) der Strahlung.

15. System nach einem der Ansprüche 12 bis 14, wobei die Mess- und Analysevorrichtung (12) umfasst:
- mindestens ein Mess- und Aufzeichnungsmittel (M), konfiguriert zum Messen der tatsächlichen Energie (EIC), die durch energetische Strahlung (R) erzeugt wird,
des Zielbereichs (C) und der realen Kollateralenergie (E3Si) auf dem Niveau von mindestens einem Bereich (Si), der an den Zielbereich (C) angrenzt, und, wo die Mess- und Analysevorrichtung (12) weiter konfiguriert ist, um die effektive Energie (EISub) auf Substratebene (Sub) zu messen, die Mess- und Aufzeichnungseinrichtung
(M) weiter konfiguriert ist, um die effektive Energie (EISub) zu messen, und Wirkzeit (TISub) auf dem Substrat (Sub) und
- mindestens ein Mittel zur Analyse und Aufzeichnung (A), das konfiguriert ist, um die tatsächliche Wirkung (Ale) zu analysieren, die auf der Ebene des bestrahlten Zielbereichs (C) erzielt wird.

## Claims

1. A method for controlled selective irradiation of a target area (C) of a surface (S) of a layer of material, such as a layer of varnish or a layer of a semiconductor material, to allow local radiation of said area
(C) in order to obtain a target effect (0), consisting of the polymerization of the layer of material,
said method being carried out by a system (1) comprising a transmitting device (11), at least one measuring and analytical device (12) and a controller device (13),
said method comprising the following steps:
A) segmentation of the said surface (S) into a plurality of zones (S1, S2... Sn);
B) entry into said control device (13) of predetermined main energy thresholds (E2S1, E2S2... E2Sn) respectively associated with each of the said zones (S1, S2... Sn) and input said target effect (0) to be obtained;
C) choice of said target area (C) from the said areas (S1, S2... Sn) and their Combinations;
D) irradiation of said target zone (C) by emission of energetic radiation (R) by said emitting device (11), said emission being controlled by said controlling device (13) for the purpose of achieving said energy thresholds predetermined principals (E2S1, E2S2... E2Sn);
E) real-time measurement and recording, by said measuring and analysis device (12), of the actual energy (EIC) generated by energetic radiation (R) at said target area (C);
F) analysis and recording, by said measuring and analysis device (12), of the actual effect (Ale) obtained at the level of said irradiated target area (C);
G) transmission of the measurement of said real energy (EIC) and the analysis of said actual effect (Ale) to said control device (13);
**H)** real-time control of said transmitting device (11) by said control device (13) during the irradiation process, taking into account said measurement of the actual energy (EIC) and said actual effect analysis (Ale) received,
said actual energy measurement (ELC) being compared to the predetermined principal energy threshold (E2C) associated with said target area (C), and said true effect (Ale) analysis being compared to said target effect (0), such that:
- HI) if the main energy threshold (E2C) is not reached and the said target effect (0) is not obtained, the emission of energetic radiation (R) over said target area (C) continuous and the power and/or intensity of said energetic radiation (R) are modulated to achieve said target effect (0);
- H2) if said principal energy threshold (E2C) is reached but said target effect (0) is not obtained, the emission of energetic radiation (R) on said target area (C) continuous and the power and/or intensity of said energetic radiation (R) are modulated to achieve said target effect (0);
- H3) if said main energy threshold (E2C) is reached and said target effect (0) is achieved, the emission of energetic radiation (R) on said target area (C) is stopped;
- H4) if the said main energy threshold (E2C) is not reached but the said target effect (0) is obtained, the emission of energetic radiation (R) over said target area (C) is stopped.

2. A method according to claim 1, further comprising the following steps:
A') entry into said control device (13) of secondary energy thresholds predetermined (E4SI, E4S2, E4Si... E4Sn) respectively associated at each of the said zones (SI, S2... Sn);
B') measurement and recording in real time, by said measuring and analysis device (12), of the real collateral energy (E3Si), generated at the level of at least one zone (Si) of said plurality of zones (SI, S2... Sn) that is adjacent to the said area
target (C), said actual collateral energy (E3Si) being generated by radiation (R) irradiating said target area (C);
C') transmission of the measurement of said real collateral energy (E3Si) to said control device (13);
(d) real-time control of said transmitting device (11) by said device controller (13) during the irradiation process, taking into account the measurement of said actual collateral energy (E3Si),
the measurement of said real collateral energy (E3Si) being compared to the predetermined secondary energy threshold (E4Si) associated with at least one zone (Si) of said plurality of zones (SI, S2... Sn) that is adjacent to said target area (C),
manner at what:
if said secondary energy threshold (E4Si) of said at least one area (Si) adjacent to said target area (C) is reached, the power and/or intensity of said energetic radiation (R) radiating said target area (C) shall be modulated to reduce said actual collateral energy (E3Si).

3. A method according to claim 1 or 2, further comprising the following steps, when said layer of material is deposited on a substrate (sub):
**(1)** input into said control device (13) of a maximum energy threshold (EMSub) associated with said substrate (Sub);
J) measurement and recording in real time, by said measuring device and analysis (12), of the effective energy (EISub) generated at the said substrate (Sub);
(K) transmission of the measurement of said effective energy (EISub) to the controller (13);
(L) real-time control of said transmitting device (11) by said device controller (13) during the irradiation process, taking into account the measurement of said effective energy (EISub),
the measurement of said effective energy (EISub) being compared with said maximum energy threshold (EMSub), such that, if said effective energy (EISub) is above said maximum energy threshold (EMSub), power and/or the intensity of said energetic radiation (R) radiating said target area (C) is modulated to reduce said effective energy (EISub) at the level of said substrate.

4. A method according to claim 3, further comprising the following steps:
(I) input into said control device (13) of an intermediate energy threshold (EISub) associated with said substrate (Sub), as well as a maximum duration (TISub) associated with the said intermediate energy threshold (EISub);
(M) real-time control of said transmitting device (11) by said controlling device (13) during the irradiation process, taking into account the measurement of said effective energy (EISub),
wherein the measurement of said effective energy (EISub) is compared to the intermediate energy threshold (EISub), and where said effective energy (EISub) corresponds to said intermediate energy threshold (EISub), said measuring and analysis device (12) measures and records in real time an effective time (TISub) corresponding to the
the length of time during which said effective energy (EISub) corresponds to said threshold (EISub), and said checking device compares said effective time (EISub) to said maximum duration (TISub), so that, if said effective time (TISub) is greater than said maximum duration (TISub), the power and/or intensity of said energetic radiation (R) irradiating said target area (C) are modulated to reduce said effective energy (EISub) at said substrate.

5. A method according to any one of claims 1 to 4, wherein said area target (C) is the entire area (S).

6. Method according to any one of Claims 1 at 5, wherein said emitting device (11) is fixed and selected from a matrix comprising a plurality of independent emitting sources (111) and at least one associated emitting source at an optical galvanometer.

7. A method according to claim 6, wherein, where said transmitting device (11) is a matrix comprising a plurality of independent emitting sources (111),
said independent emitting sources (111) are LEDs.

8. A method according to any one of claims 1 to 5, wherein said transmitting device (11) is mobile, such as a moving source embedded on an axis.

9. A method according to any one of claims 1 to 8, wherein said device measurement and analysis sensor (12) is a thermal and/or radiative imaging sensor, associated with at an image analysis module.

10. A method according to any one of claims 1 to 9, wherein said control device (13) is a human-machine interface.

11. A method according to any one of claims 1 to 10, wherein said Energetic radiation (R) is chosen from visible, infrared, gamma, ultraviolet, laser, microwave, X-ray, and convective or conductive thermal deployment.

12. System (1) for controlled selective irradiation of a target area (C) of a surface (S) of a layer of material, such as a layer of varnish or a layer of a material
of a semiconductor, said surface (S) being segmented into a plurality of zones (SI, S2, Si... Sn), said system (1) implementing the method according to any one of Claims 1 at 11, including:
- a transmitting device (11), configured to irradiate said target area (C) with energetic radiation (R),
- at least one measurement and analysis device (12), configured to measure the actual energy (EIC) generated by energetic radiation (R) at the level of said target zone (C) and the real collateral energy (E3Si) generated at the level of at least one zone (Si) of said plurality of zones (SI, S2... Sn) which is adjacent to said target area (C), as well as to analyse the actual effect (Ale) obtained at the level of said area
irradiated target (C),
- a controller device (13), configured to receive predetermined main energy thresholds (E2SI, E2S2... E2Sn) and secondary (E4SI, E4S2, E4Si... E4Sn) respectively associated with each of the said zones (SI, S2... Sn) and a target effect (0) to be obtained, as well as to receive the measurement of said actual energy (EIC) and said
the real collateral energy (E3Si), as well as the analysis of said real effect (Ale), said control device (13) comprising means for comparing said actual energy (EIC) measurement at the predetermined primary energy threshold (E2C) associated with said target zone (C), from said actual collateral energy measurement (E3Si) to the secondary predetermined energy threshold (E4Si) of at least one zone (Si)
Adjacent at said target area (C), and said actual effect analysis (Ale) said target effect (0),
said control device (13) further being configured to control said transmitting device (11) in real time during the irradiation process by stopping the emission of said energetic radiation (R), and/or by power modulation and/or
the intensity of the said energetic radiation (R), and/or by selective modulation of the irradiated areas.

13. The system of claim 12, wherein said measuring and analytical apparatus (12) is further configured to measure the effective energy (EISub) at a substrate (Sub) on which said layer of material has been deposited, and wherein said controller device (13) is further configured to receive a maximum energy threshold (EMSub) associated with said substrate (Sub), said control device (13) also comprising means of comparing said effective energy measurement (EISub) with said maximum energy threshold (EMSub).

14. The system of claim 13, wherein said control device (13) is in
in addition configured to receive an associated intermediate energy threshold (EISub) substrate audit (Sub) and a maximum duration (TISub) associated with said energy threshold
(EISub), said control device (13) further comprising means of comparison of said effective energy measurement (EISub) said intermediate energy threshold (EISub), and wherein, where said effective energy
(EISub) corresponds to the said intermediate energy threshold (EISub), said The measurement and analysis (12) is further configured to measure the effective time (TISub) during which said effective energy (EISub) corresponds to said intermediate energy threshold (EISub), and said control device (13) further comprising means for comparing said effective time (TISub) to said duration maximum (TISub) of irradiation.

15. A system according to any one of claims 12 to 14, wherein said measuring and analytical apparatus (12) comprises:
- at least one measurement and recording means (M) configured to measure said actual energy (EIC) generated by energetic radiation (R) at of said target area (C) and said real collateral energy (E3Si) at the level of at least one area (Si) adjacent to said target area (C), and, where said measuring and analytical device (12) is further configured to measure effective energy (EISub) at the substrate level (Sub), said measurement and recording means
(M) is further configured to measure said effective energy (EISub) and said effective time (TISub) at said substrate (Sub), and
- at least one means of analysis and recording (A) configured to analyse said actual effect (Ale) obtained at the level of said irradiated target area (C).
